Europäisches Patentamt

European Patent Office

Office européen des brevets

(11) Publication number: **0 412 000 B1**

# EUROPEAN PATENT SPECIFICATION

(45) Date of publication of patent specification: **12.04.95**  (51) Int. Cl.6: **C23C 14/22**, C23C 14/32, C23C 14/58, C23C 14/08, H01L 39/24

(21) Application number: **90402187.0**

(22) Date of filing: **31.07.90**

(54) **Process for preparing superconducting thin films.**

(30) Priority: **31.07.89 JP 198648/89**

(43) Date of publication of application:
**06.02.91 Bulletin  91/06**

(45) Publication of the grant of the patent:
**12.04.95 Bulletin  95/15**

(84) Designated Contracting States:
**DE FR GB**

(56) References cited:
**DE-A- 3 839 903**

**APPLIED PHYSICS LETTERS, vol. 53, no. 5, 1st August 1988, pages 441-443, American Institute of Physics, New York, NY, US; R.J. SPAH et al.: "Parameters for in situ growth of high Tc superconducting thin films using an oxygen plasma source"**

**JAPANESE JOURNAL OF APPLIED PHYSICS, vol. 27, no. 1, January 1988, pages L91-L93, Tokyo, JP; T. TERASHIMA et al.: "Single-crystal YBa2Cu3O7-x thin films by activated reactive evaporation"**

(73) Proprietor: **SUMITOMO ELECTRIC INDUSTRIES, LTD.**
**5-33, Kitahama 4-chome,**
**Chuo-ku**
**Osaka-shi,**
**Osaka 541 (JP)**

(72) Inventor: **Nakanishi, Hidenori**
**Cabinet Ballot-Schmit,**
**7, rue Le Sueur**
**F-75116 Paris (FR)**
Inventor: **Itozaki, Hideo**
**Cabinet Ballot-Schmit,**
**7, rue Le Sueur**
**F-75116 Paris (FR)**
Inventor: **Matsuura, Takashi**
**Cabinet Ballot-Schmit,**
**7, rue Le Sueur**
**F-75116 Paris (FR)**

(74) Representative: **Ballot, Paul Denis Jacques et al**
**Cabinet Ballot-Schmit,**
**7, rue Le Sueur**
**F-75116 Paris (FR)**

EP 0 412 000 B1

**Description**

Background of the related art

Field of the invention

The present invention relates to a process for preparing superconducting thin films. More particularly, it relates to an improved process for depositing a superconducting thin film of Bi-containing compound oxide deposited on a substrate at relatively lower temperatures.

Description of the related art

The superconductivity which is explained to be a phase change of electrons was thought to be a phenomenon which can be observed under extremely low temperature. However, in 1986, Bednorz and Müller discovered a new oxide type superconductor [La, Sr]$_2$CuO$_4$ which shows superconductivity at 30 K (Z. Phys. B64, 1986 p 189). C. W. Chu et al. discovered another superconducting material of YBa$_2$Cu$_3$O$_{7-x}$ which shows the critical temperature of about 90 K in 1987 (Physical Review letters, Vol. 58, No. 9, p 908). Maeda et al discovered Bi-containing superconductor in 1988 (Japanese Journal of Applied Physics. Vol. 27, No. 2, p 1209 to 1210). In these newly discovered oxide superconductors, the superconductive phenomenon can be realized with relatively cheaper liquid nitrogen and hence the possibility of an actual utilization of the high Tc superconductors have burst onto the scene.

The above-mentioned oxide superconductors were prepared in a bulk form of sintered block by powder sintering technique. The sintered articles, however, show very poor critical current density. In order to overcome this problem, a variety of deposition techniques have been studied to prepare thin films of these superconductors. Although it was indispensable to subject deposited thin films to post-annealing at high temperatures in the early stage of development of oxide superconducting thin films, a recent vacuum deposition technology makes it possible to prepare oxide superconducting thin films without such post-annealing.

Ion-plating method is one of typical deposition techniques. In this method, generally, metal elements which are constituent elements of a superconducting oxide are ion-plated in a RF plasma which is created in a vacuum chamber while oxygen gas is supplied through a pipe onto a surface of a substrate.

Japanese Journal of Applied Physics vol. 27 (1988) L91 to L93 proposes to after-treat a thin film deposited on a substrate with oxygen gas which is introduced into a vacuum chamber after the thin film is formed by vacuum deposition technique.

Owing to these new technologies, it has become possible to prepare superconducting thin films of relatively higher qualities. However, it is still indispensable to maintain the substrate at a relatively high temperatures such as 600 °C during the deposition in order to obtain thin films which possess effective superconducting properties. Such high substrate temperature, however, is not desirable because migration or diffusion of elements of which the substrate is composed such as MgO can not be negligible and hence the superconducting properties are spoiled. Applied Physic Letters, Vol. 53, n° 5 (1988) pp 441-443 discloses a molecular beam deposition process for growing thin films of Dy-Ba-Cu-O in presence of dissociated oxygen from a glow discharge source on a relatively low temperature substrate kept below 600°C followed by an in situ anneal below 400°C.

DE-A-38 39 903 discloses a process for producing a superconducting layer of the Y-Ba-Cu-O type on a substrate after annealing for at least 30 mn at atmospheric pressure in an oxidising atmosphere at temperature below 500°C of a thin layer previously deposited in the substrate.

An object of the present invention is also to solve the problems of the known techniques by lowering the substrate temperature and to provide a process which can prepare superconducting thin films of high quality.

Summary of the Invention

The present invention provides a process for forming a superconducting thin film of compound oxide on a substrate by depositing constituent elements of which the compound oxide is composed on the substrate in a vacuum chamber under the presence of high-frequency plasma while oxygen gas is supplied through a nozzle onto a surface of the substrate, characterized

in that said superconducting thin film is deposited on the substrate under the presence of high-frequency plasma created at a high-frequency power between 100 and 600 W with maintaining the oxygen gas supplied through said nozzle arrange in the neighborhood of said surface at such a flow rate that can realize a deposition rate between 0.4 and 0.5 nm/s (4 to 5 Å/sec),

in that, after the deposition complete, the substrate having a deposited thin film thereon is further after-treated in the same vacuum chamber at substrate temperature between 300°C and 600°C under the presence of high-frequency plasma with maintaining the oxygen gas supply whose flow rate is at least equal to that of deposition stage for a time between 0.5 to 2 hours, and

in that, after the after-treatment complete, the after-treated substrate having the deposited thin film thereon is further heat-treated in oxygen gas of about $10^5$ Pa (1 atm) in the vacuum chamber.

The process according to the present invention is applicable to all known compound oxides which can be formed in thin films. Followings are examples of oxide superconductors to which the present process is advantageously applicable :

(a) $(La_{1-x},\alpha)_2 \, Cu \, O_{4-y}$

in which "$\alpha$" stands for Sr or Ba, and "x" and "y" are numbers each satisfying respective range of $0 \leq x < 1$ and $0 \leq y < 1$,

(b) $Ln_1 \, Ba_2 \, Cu_3 \, O_{7-z}$

in which "Ln" stands for at least one element selected from a group comprising La, Ce, Pr, Nd, Sm, Eu, Gd, Tb, Dy, Ho, Y, Er, Tm, Yb and Lu, and "z" is a number satisfying a range of $0 \leq z < 1$.

(c) $Bi_4 \, (Sr_{1-x}, Ca_x)_m \, Cu_n \, O_{p+y}$

in which "x", "m", "n", "p" and "y" are numbers each satisfying ranges of $6 \leq m \leq 10$, $4 \leq n \leq 8$, $0 < x < 1$ and $-2 \leq y \leq +2$, respectively and $p = (6+m+n)$.

In this system, following compositions are preferable:
(i) $7 \leq m \leq 9$,     $5 \leq n \leq 7$     $0.4 < x < 0.6$
(ii) $6 \leq m \leq 7$,     $4 \leq n \leq 5$     $0.2 < x < 0.4$
(iii) $9 \leq m \leq 10$,     $7 \leq n \leq 8$     $0.5 < x < 0.7$

(d) $Bi_{2-y} \, Pb_y \, Sr_2 \, Ca_{n-1} \, Cu_n \, O_x$

in which "y", "n" and "x" are numbers each satisfying a range of $0.1 \leq y \leq 1$, $1 \leq n \leq 6$ and $6 \leq x \leq 16$ respectively.

The substrate is preferably a single crystal substrate of oxide, particularly an oxide of MgO, $SrTiO_3$ or yttrium stabilized zirconia (YSZ). The other substrates which can be used in the present invention include single crystals of $LaGaO_3$, $NdGaO_3$ and $LaAlO_3$.

In the deposition stage, constituent metal elements of which the compound oxide is composed is deposited on the substrate in a vacuum chamber under the presence of high-frequency plasma created at high frequency power between 100 and 600 W while oxygen gas is supplied through a nozzle onto a surface of the substrate. This deposition of compound oxide can be effected by means of vacuum deposition, sputtering, ion-plating, molecular beam epitaxial growth (MBE) or the like. The high-frequency plasma can be created by applying radio frequency (RF) between the substrate and target(s) or vapour source(s).

The oxygen gas supplied onto a surface of the substrate is effected through a nozzle which is arranged in the neighborhood of the surface of the substrate. The oxygen gas may be excited by microwave or can be ozonized.

Conditions of film-formation depend on the compound oxide to be deposited. A typical film-forming condition of a superconducting compound oxide represented by $HoBa_2Cu_3O_{7-y}$ is shown hereunder:

| Vapour sources (by electron beam gun) | Ho pellet, $BaF_2$ pellet and Cu granule |
|---|---|
| Substrate | MgO single crystal {100} or {110} plane |
| Substrate temperature | 520 °C to 600 °C |
| Pressure in vacuum chamber | $1,3x10^{-3}$ to $5,2x10$-3 Pa ($10^{-5}$ to $4x10^{-5}$ Torr) |
| High-frequency power | 100 to 600 W |
| Oxygen flow rate | 20 to 30 cc/min |
| Deposition rate | $4x10^{-10}$ to $5x10^{-10}$ m/s (4 to 5 Å/s) |
| Thickness | $1,5x10^{-7}$ to $2x10$-7 m (1500 to 2000 Å) |

Persons skilled in the arts can easily find the optimum conditions of the film-formation for given deposition unit and compound oxide material used by experiments.

An essence of the present invention resides in that, just after the deposition complete, the substrate having a deposited thin film thereon is further after-treated with oxygen in the same vacuum chamber at predetermined conditions.

More precisely, in the process according to the present invention, oxygen supply onto the thin film deposited is continued after the deposition with keeping a substrate temperature between 300 °C and 600 °C under the presence of high-frequency plasma. This operation is preferably continued for a time duration between 0.5 to 2 hours.

The after-treatment according to the present invention accelerate oxidation of the thin film and the substrate in such a manner that escape of oxygen from the thin film deposited can be prevented effectively and that chemical reduction of the thin film caused by the substrate material can be prevented. In other words, epitaxial growth of oxide thin film can be assured by the after-treatment according to the present invention even at relatively lower substrate temperatures because sufficient amount of oxygen is supplied to the thin film. Still more, the low substrate temperatures can suppress effectively emigration or diffusion of substrate material. As a result, the superconducting thin films prepared by the process according to the present invention exhibit improved and stable superconducting properties.

The oxygen supply according to the present invention at the after-treatment stage is effected at a substrate temperature above 300 °C under the same intensity of high-frequency plasma as that of the deposition stage. If the substrate temperature is not above 300 °C, an effective advantage obtained by a reaction between oxygen supplied and elements in the thin film can not be expected. In this sense, higher substrate temperature is preferable. However, when the substrate temperature exceeds above 600 °C, such advantage of the present invention that the deposition can be carried out at relatively low temperatures is lost and the quality of the thin film is deteriorated.

Preferably, the flow rate of oxygen supply at the after-treatment stage is at least equal to that of at the deposition stage. If the oxygen flow rate is lower than that of at the deposition stage, it is difficult to suppress effectively escape of oxygen atom out of the thin film during the after-treatment. And hence, the flow rate of oxygen supply at the after-treatment stage is selected at a higher value than that of at the deposition stage. Generally, the oxygen flow rates are selected from the following ranges for a substrate of 10 x 20 mm :

| At the deposition stage: | 30 to 40 cc/min |
|---|---|
| At the after-treatment stage: | 40 to 80 cc/min |

The thin film obtained by the process according to the present invention is subjected additionally to the conventional post-annealing or post-oxygen treatment in which the thin film is exposed usually to oxygen gas of about $10^5$ Pa (1 atm) at 880 to 920 °C.

The most important advantage of the process according to the present invention is that it is possible to obtain a superconducting thin film which exhibits improved superconducting properties at relatively lower substrate temperatures. Namely, oxidation of the thin film is accelerated, escaped of oxygen from the thin film is prevented, chemical reduction of the thin film is prevented and an oxide thin film can be grown epitaxially. Still more, emigration or diffusion of substrate material can be suppressed because of the low-temperature process. Therefore, the process according to the present invention is advantageously applicable to produce a SIS (superconductor-insulator-superconductor) junction as well as production of simple superconducting thin films.

Brief Description of the drawings

FIG. 1 is a graph showing a relation between resistance and temperature of a superconducting thin film, a curve (a) corresponding to the present invention and a curve (b) corresponding to the prior art.

Fig. 2 is a graph of the critical temperatures which are plotted in function of the substrate temperatures.

Now, the present invention will be described with reference to Examples, but the scope of the invention should not be limited to the Examples.

Example 1

A superconducting compound oxide represented by $HoBa_2Cu_3O_{7-y}$ was deposited on a MgO single crystal in an ion-plating machine.

As vapour sources of constituent elements of the compound oxide, pellets of Ho and $BaF_2$ and granules of Cu were used. The thin film was deposited on {100} plane of a MgO single crystal substrate (10 x 20 x 0.5 mm).

After the substrate was set in a vacuum chamber, the vacuum chamber was evacuated to a pressure of $1,3x10^{-3}$ Pa (1 x 10-5 Torr) and the substrate was heated to 520°C.

Then, a high-frequency power of 600 W was applied between the substrate and the vapour sources to create high-frequency plasma in a zone between them. While oxygen gas was supplied onto a surface of the substrate at a flow rate of about 40 cc/min by means of a nozzle which is opened at a distance of 13 mm from the surface of the substrate, the vapour sources were heated by electron beam guns and evaporated. The deposition rate was adjusted to $4x10^{-10}$ to $5x10^{-10}$ m/s (4 to 5 Å/sec).

After a thin film of compound oxide having a thickness of $2x10^{-7}$ m (2000 Å) was deposited on the substrate, the flow rate of oxygen gas was increased to 80 cc/min with maintaining the same substrate temperature of 520 °C and the same high-frequency power of 600 W and the substrate was left in the vacuum chamber for 30 minutes.

Then, oxygen gas of 1 atm was introduced into the vacuum chamber with maintaining the same substrate temperature of 520 °C and the substrate was left in the vacuum chamber for another 30 minutes. After then, a heater for the substrate was de-energized to cool the substrate down to room temperature.

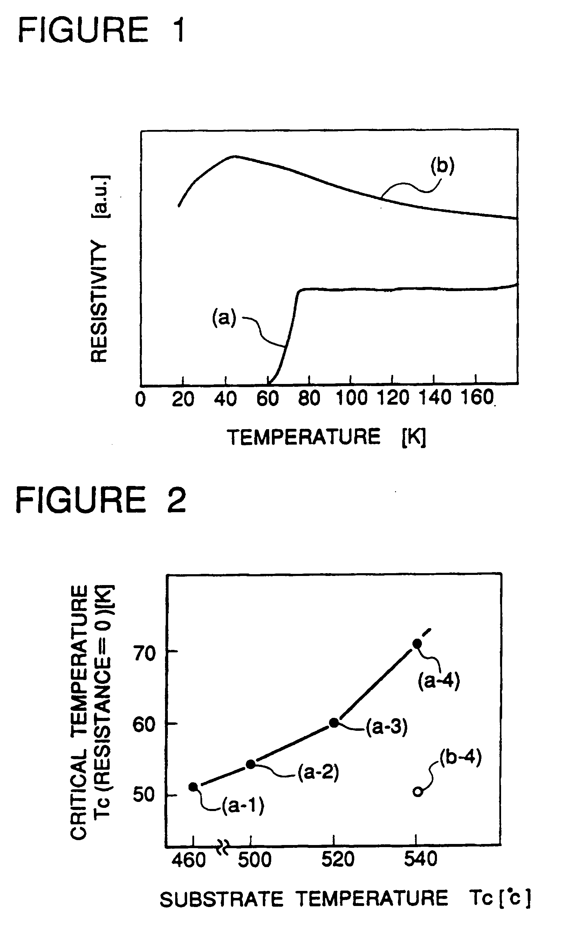

A superconducting property of the resulting sample (a) according to the present invention was evaluated by the temperature dependency of resistance which was determined by dipping the sample (a) in liquid helium to confirm the superconducting phenomenon and then by rising the temperature gradually. The result is shown in Fig. 1.

In order to prepare a comparative example (b), the same deposition procedure as above was repeated but the after-treatment was modified in such a manner that oxygen gas of $10^5$ Pa (1 atm) was introduced into the vacuum chamber just after the deposition step and the substrate was maintained at 520 °C for 30 minutes. The test result of this comparative example (b) is also shown in Fig. 1.

Fig. 1 reveals that the resistance of the sample (a) according to the present invention starts to drop at a higher temperature and becomes to a unmeasurable condition soon after the drop, while the resistance of the comparative sample (b) doesn't drop above 40 K and doesn't reach to the unmeasurable condition.

As is shown in Example 2, the superconducting property of the comparative sample (b) could not obtained if the substrate is not heated above 540 °C.

Example 2

The same procedure for producing the sample (a) as Example 1 was repeated except the substrate temperature were modified to 460 °C [sample (a-1)], 500 °C [sample (a-2)], 520 °C [sample (a-3)] and 540 °C [sample (a-4)].

Also, the same procedure for producing the sample (b) as Example 1 was repeated except the substrate temperature were modified to 460 °C [sample (b-1)], 500 °C [sample (b-2)], 520 °C [sample (b-3)] and 540 °C [sample (b-4)].

The superconductive property of these six samples were evaluated by the same method as Example 1. Fig. 2 shows temperatures where the resistance became unmeasurable condition with respect to the substrate temperatures. In the cases of the comparative sample (b-1), sample (b-2) and sample (b-3) which were prepared at the substrate temperatures of 460 °C, 500 °C and 520 °C respectively, no effective superconducting property was observed.

Fig. 2 proves such a fact that the process according to the present invention can produce superconductiing thin films which exhibit high critical temperatures even if the substrate temperatures are lowered.

**Claims**

1. A process for forming a superconducting thin film of compound oxide on a substrate by depositing constituent elements of which the compound oxide is composed on the substrate in a vacuum chamber under the presence of high-frequency plasma while oxygen gas is supplied through a nozzle onto a surface of the substrate, characterized

   in that said superconducting thin film, is deposited on the substrate under the presence of high-frequency plasma created at a high-frequency power between 100 and 600 W with maintaining the oxygen gas supplied through said nozzle arrange in the neighborhood of said surface at such a flow rate that can realize high deposition rate between 0.4 and 0.5 nm/s (4 to 5 Å/sec),

   in that, after the deposition complete, tile substrate having a deposited thin film thereon is further after-treated in the same vacuum chamber at a substrate temperature between 300 °C and 600 °C under the presence of high-frequency plasma with maintaining the oxygen gas supply whose flow rate is at least equal to that of deposition stage for a time between 0.5 to 2 hours, and

   in that, after the after-treatment complete, the after-treated substrate having the deposited thin film thereon is further heat-treated in oxygen gas of about $10^5$ Pa (1 atm) in the vacuum chamber.

2. The process set forth in Claim 1, wherein said oxygen gas supply onto said substrate during the after-treatment is between 20 and 100 cc/min.

3. The process set forth in any one of Claim 1 to 2, wherein the deposition of said superconducting thin film is effected in an ion-plating unit.

4. The process set forth in any one of Claim 1 to 5, wherein said superconducting thin film is made of a compound oxide having a composition represented by the formula :

   $$(La_{1-x}, \alpha)_2 Cu O_{4-y}$$

   in which "$\alpha$" stands for Sr or Ba, and "x" and "y" are numbers each satisfying respective range of $0 \leq x < 1$ and $0 \leq y < 1$.

5. The process set forth in any one of Claim 1 to 3, wherein said superconducting thin film is made of a compound oxide having a composition represented by the formula :

   $$Ln_1 Ba_2 Cu_3 O_{7-z}$$

   in which "Ln" stands for at least one element selected from the group comprising La, Ce, Pr, Nd, Sm, Eu, Gd, Tb, Dy, Ho, Y, Er, Tm, Yb and Lu, and "z" is a number satisfying a range of $0 \leq z < 1$.

6. The process set forth in any one of Claim 1 to 3, wherein said superconducting thin film is made of a compound oxide having a composition represented by the formula :

   $$Bi_4 (Sr_{1-x}, Ca_x)_m Cu_n O_{p+y}$$

   in which "x", "m", "n", "p" and "y" are numbers each satisfying ranges of
   $6 \leq m \leq 10$, $4 \leq n \leq 8$ $0 < x < 1$ and $-2 \leq y \leq +2$, respectively and $p = (6 + m + n)$.

7. The process set forth in any one of Claim 1 to 6, wherein said substrate is of a single crystal of an oxide.

8. The process set forth in Claim 7, wherein said substrate is of a single crystal of an oxide selected from a group comprising MgO, SrTiO₃ and YSZ.

**Patentansprüche**

1. Verfahren zur Bildung einer supraleitenden dünnen Schicht aus Verbundoxid auf einem Substrat durch Abscheiden der das Verbundoxid bildenden Elemente auf dem Substrat in einer Vakuumkammer in Gegenwart eines Hochfrequenzplasmas, während Sauerstoff der Substratoberfläche durch eine Düse hindurch zugeführt wird, dadurch gekennzeichnet, daß die supraleitende dünne Schicht auf dem Substrat abgeschieden wird in Gegenwart des Hochfrequenzplasmas, das mittels einer Hochfrequenzleistung zwischen 100 und 600 W erzeugt wird, und wobei die Sauerstoffgaszufuhr durch die Düse hindurch in der Nähe der Oberfläche mit einer derartigen Durchflußrate erfolgt, daß eine hohe Abscheiderate zwischen 0,4 und 0,5 nm/s (4 bis 5 Å/sec) erzielt wird,

daß nach der vollständigen Abscheidung das mit der dünnen Schicht versehene Substrat in der gleichen Vakuumkammer bei einer Substrattemperatur zwischen 300°C und 600°C nachbehandelt wird in Gegenwart eines Hochfrequenzplasmas, mit aufrecht erhaltener Sauerstoffgaszufuhr, dessen Durchflußrate wenigstens gleich derjenigen während der Abscheidung ist, für einen Zeitraum zwischen 0,5 und 2 Stunden und

daß nach der vollständigen Nachbehandlung das nachbehandelte Substrat mit der abgeschiedenen dünnen Schicht einer weiteren Wärmebehandlung in Sauerstoffgas bei ungefähr $10^5$ Pa (1 atm) in der Vakuumkammer unterworfen wird.

2.  Verfahren nach Anspruch 1, bei dem die Sauerstoffgaszufuhr zum Substrat während der Nachbehandlung zwischen 20 und 100 cc/min beträgt.

3.  Verfahren nach einem der Ansprüche 1 bis 2, bei dem die Abscheidung der supraleitenden dünnen Schicht in einer Ionen-Plattier-Einheit erfolgt.

4.  Verfahren nach einem der Ansprüche 1 bis 5, bei dem die supraleitende dünne Schicht aus einem Verbundoxid besteht, dessen Zusammensetzung durch die Formel gegeben ist

$$(La_{1-x}, \alpha)_2 CuO_{4-y}$$

wobei $\alpha$ für Sr oder Ba steht und x und y Zahlen sind, welche die Bereiche $0 \leq x < 1$ bzw. $0 \leq y < 1$ erfüllen.

5.  Verfahren nach einem der Ansprüche 1 bis 3, bei dem die supraleitende dünne Schicht aus einem Verbundoxid besteht, dessen Zusammensetzung durch die Formel gegeben ist

$$Ln_1 Ba_2 Cu_3 O_{7-z}$$

wobei Ln für wenigstens ein Element steht, das ausgewählt ist aus der Gruppe umfassend La, Ce, Pr, Nd, Sm, Eu, Gd, Tb, Dy, Ho, Y, Er, Tm, Yb und Lu und z eine Zahl ist, welche den Bereich $0 \leq z < 1$ erfüllt.

6.  Verfahren nach einem der Ansprüche 1 bis 3, bei dem die supraleitende dünne Schicht aus einem Verbundoxid besteht, dessen Zusammensetzung durch die Formel gegeben ist

$$Bi_4 (Sr_{1-x}, Ca_x)_m Cu_n O_{p+y}$$

wobei x, m, n, p und y Zahlen sind, welche die Bereiche
$6 \leq m \leq 10$, $4 \leq n \leq 8$, $0 < x < 1$, $-2 \leq y \leq +2$ bzw. $p = (6+m+n)$ erfüllen.

7.  Verfahren nach einem der Ansprüche 1 bis 6, bei dem das Substrat ein Oxid-Einkristall ist.

8.  Verfahren nach Anspruch 7, bei dem das Substrat ein Oxid-Einkristall ist, der aus der Gruppe ausgewählt ist umfassend MgO, $SrTiO_3$ und YSZ.

**Revendications**

1.  Procédé pour former une couche mince supraconductrice d'oxyde composé sur un substrat, en déposant les constituants, qui composent l'oxyde composé, sur le substrat dans une chambre à dépression en présence d'un plasma haute fréquence, avec amenée d'oxygène, par l'intermédiaire d'une buse, sur une surface du substrat, caractérisé

en ce que ladite couche mince supraconductrice est déposée sur le substrat en présence du plasma haute fréquence créé à un niveau de puissance haute fréquence situé entre 100 et 600 W tout

EP 0 412 000 B1

en maintenant l'amenée d'oxygène par l'intermédiaire de ladite buse, disposée à proximité de ladite surface, à un débit propre à permettre l'obtention d'une vitesse de dépôt élevée, située entre 0,4 et 0,5 nm/s (4 à 5 Å/s),

en ce que, lorsque le dépôt est terminé, le substrat comportant une couche mince déposée sur lui est soumis à un post-traitement dans la même chambre à dépression à une température du substrat située entre 300 °C et 600 °C en présence d'un plasma haute fréquence tout en maintenant l'amenée d'oxygène à un débit au moins égal à celui de l'étape du dépôt, pour une durée comprise entre 0,5 à 2 heures, et

en ce que, une fois le post-traitement terminé, le substrat post-traité, comportant la couche mince déposée sur lui, est soumis à un post-traitement thermique supplémentaire dans l'oxygène à environ $10^5$ Pa (1 atm) dans la chambre à dépression.

2. Procédé selon la revendication 1, dans lequel ladite amenée d'oxygène sur ledit substrat pendant le post-traitement est effectué à un débit situé entre 20 et 100 cc/min.

3. Procédé selon l'une quelconque des revendications 1 à 2, dans lequel le dépôt de ladite couche mince supraconductrice est effectué dans une unité de placage ionique.

4. Procédé selon l'une quelconque des revendications 1 à 5, dans lequel ladite couche mince supraconductrice est faite d'un oxyde composé ayant une composition représentée par la formule :

$(La_{1-x}, \alpha)_2 Cu O_{4-y}$

où "$\alpha$" représente Sr ou Ba, et "x" et "y" sont des nombres satisfaisant chacun à la fourchette respective $0 \leq x < 1$ et $0 \leq y < 1$.

5. Procédé selon l'une quelconque des revendications 1 à 3, dans lequel ladite couche mince supraconductrice est faite d'un oxyde composé ayant une composition représentée par la formule :

$Ln_1 Ba_2 Cu_3 O_{7-z}$

où "Ln" représente au moins un élément sélectionné à partir du groupe comprenant le La, le Ce, le Pr, le Nd, le Sm, l'Eu, le Gd, le Tb, le Dy, l'Ho, l'Y, l'Er, le Tm, l'Yb et le Lu, et où "z" est un nombre satisfaisant à la fourchette $0 \leq z < 1$.

6. Procédé selon l'une quelconque des revendications 1 a 3, dans lequel ladite couche mince supraconductrice est faite d'un oxyde composé ayant une composition représentée par la formule :

$Bi_4 (Sr_{1-x}, Ca_x)_m Cu_n O_{p+y}$

où "x", "m", "n", "p" et "y" sont des nombres satisfaisant chacun aux fourchettes respectives
$6 \leq m \leq 10, 4 \leq n \leq 8, 0 < x < 1$ et $-2 \leq y \leq +2$, et $p = (6 + m + n)$.

7. Procédé selon l'une quelconque des revendications 1 à 6, dans lequel ledit substrat est un monocristal d'un oxyde.

8. Procédé selon la revendication 7, dans lequel ledit substrat est fait d'un monocristal d'un oxyde sélectionné à partir du groupe comprenant le MgO, le $SrTiO_3$ et l'YSZ.

8

# FIGURE 1

# FIGURE 2